# DEMANDE DE BREVET EUROPEEN

(11) **EP 2 835 825 A1**
(43) Date de publication de la demande: **11.02.2015**
(21) Numéro de dépôt: 14178657.4
(22) Date de dépôt: 25.07.2014
(51) Int. Cl.: H01L 27/02, H01L 27/12, H01L 29/74, H01L 29/749, H01L 29/423, H01L 29/10

(54) **Circuit integre sur soi muni d'un dispositif de protection contre les decharges electrostatiques**

(30) Priorité: 05.08.2013 FR 1357769
(71) Demandeur: Commissariat à l'Énergie Atomique et aux Énergies Alternatives, 75015 Paris (FR); STmicroelectronics SA, 92120 Montrouge (FR); Centre National de la Recherche Scientifique, 75016 Paris (FR)
(72) Inventeur: Solaro, Yohann, 38000 GRENOBLE (FR); Cristoloveanu, Sorin, 38170 SEYSSINET PARISET (FR); Fenouillet-Beranger, Claire, 38500 VOIRON (FR); Fonteneau, Pascal, 38570 THEYS (FR)
(74) Mandataire: GIE Innovation Competence Group

(57) **Abrégé**

L'invention concerne un circuit intégré, comprenant un dispositif de protection contre les décharges électrostatiques incluant :
-une couche isolante enterrée (2) comportant une épaisseur inférieure ou égale à 50nm ;
-des premiers et deuxième transistors bipolaires disposés sur la couche isolante enterrée (2), un de ces transistors bipolaires étant un transistor NPN, l'autre de ces transistors étant un transistor PNP, la base du premier transistor bipolaire étant confondue avec le collecteur du deuxième transistor bipolaire et la base du deuxième transistor bipolaire étant confondue avec le collecteur du premier transistor bipolaire, les premier et deuxième transistors bipolaires étant configurés pour conduire sélectivement un courant de décharge entre deux électrodes (A, K) du dispositif de protection ;
-un premier plan de masse semi-conducteur (93) disposé sous la couche isolante enterrée, adapté à être polarisé électriquement, s'étendant à l'aplomb de la base (43) du premier transistor bipolaire, présentant un premier type de dopage identique à celui de la base du premier transistor bipolaire et présentant une densité de dopage au moins dix fois supérieure à celle de la base du premier transistor bipolaire.

## Description

L'invention concerne les circuits intégrés, et en particulier les circuits intégrés réalisés sur un substrat de type silicium sur isolant (SOI). La technologie SOI consiste à séparer une fine couche de silicium (quelques nanomètres) sur un substrat en silicium par une couche d'isolant relativement épaisse (quelques dizaines de nanomètres en règle générale).

Les circuits intégrés réalisés en technologie SOI présentent un certain nombre d'avantages. De tels circuits présentent généralement une plus faible consommation électrique pour des performances équivalentes. De tels circuits induisent également des capacités parasites plus faibles, qui permettent d'améliorer la vitesse de commutation. De plus, le phénomène de déclenchement parasite (« latchup » en langue anglaise) rencontré par les transistors MOS en technologie Bulk peut être évité. De tels circuits s'avèrent donc particulièrement adaptés pour des applications de type SoC ou MEMS. On constate également que les circuits intégrés SOI sont moins sensibles aux effets des radiations ionisantes et s'avèrent ainsi plus fiables dans des applications où de telles radiations peuvent induire des problèmes de fonctionnement, notamment dans des applications spatiales. Les circuits intégrés SOI peuvent notamment comprendre des mémoires vives de type SRAM ou des portes logiques.

De façon connue, de tels circuits intégrés incluent également des dispositifs de protection contre des décharges électrostatiques (ESD, pour « Electrostatic Discharge » en langue anglaise) accidentelles et pouvant détériorer ces transistors.

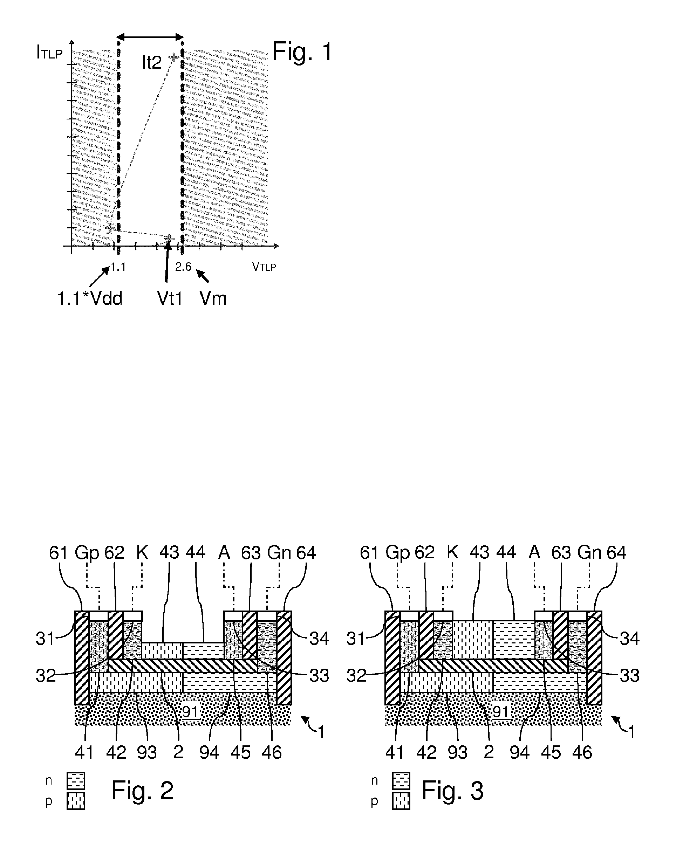

La conception d'un dispositif ESD est réalisée pour respecter un certain nombre de contraintes technologiques. La figure 1 est un exemple de diagramme tension/courant d'un dispositif ESD durant une décharge. Lors de l'apparition d'une décharge électrostatique, la tension aux bornes du dispositif ESD croît d'abord jusqu'à une tension de déclenchement Vt1. Le courant traversant le dispositif ESD croît également faiblement (faible fuite). Cette tension Vt1 doit rester inférieure à une tension Vm, correspondant à une tension de claquage en technologie MOS, typiquement de 2,6V pour du FDSOI avec un noeud technologique de 28nm. La tension Vt1 est également supérieure à une tension d'alimentation Vdd des différents circuits afin d'éviter un déclenchement intempestif du dispositif ESD. La tension Vt1 est ainsi typiquement supérieure à une tension de 1,1* Vdd.

Lorsque la tension de déclenchement Vt1 est atteinte, le dispositif ESD se déclenche. Dans un premier temps, la tension aux bornes du dispositif ESD peut décroître, le courant le traversant continuant d'augmenter. Dans un second temps, la tension aux bornes du dispositif ESD croît, de même que le courant le traversant afin de court-circuiter le courant de décharge électrostatique. Durant ce second temps, le dispositif ESD doit présenter une résistance de conduction aussi faible que possible, afin de présenter une intensité maximale de court-circuit It2 aussi élevée que possible pour une tension inférieure à la tension Vm.

Par ailleurs, le dispositif ESD doit également présenter un courant de fuite aussi faible que possible avant son déclenchement, afin de réduire la consommation électrique du circuit intégré.

Les dispositifs ESD occupent souvent une surface non négligeable du circuit intégré, qu'il est souhaitable de minimiser. Par ailleurs, le procédé de fabrication d'un dispositif ESD doit induire un minimum d'étapes supplémentaires pour ne pas accroître excessivement le coût du circuit intégré.

Le document US20050212051 décrit un dispositif ESD comprenant un transistor bipolaire PNP et un transistor bipolaire NPN, formés sur une couche d'isolant enterrée épaisse. Des contacts de base sont formés par des zones latérales fortement dopées. Un circuit additionnel assure un contrôle en courant de décharge sur des contacts de base.

Ce dispositif ESD présente cependant plusieurs inconvénients. Un circuit additionnel est nécessaire pour assurer le contrôle en courant de décharge par l'intermédiaire du transistor MOS, ce qui induit une baisse de densité d'intégration et une complexité accrue du circuit intégré. Un tel dispositif ESD présente en outre une grande complexité d'interconnexion, et nécessite d'optimiser le dopage des bases, ce qui implique donc d'utiliser un grand nombre de masques de photolithographie.

Le document US7791102 décrit un dispositif ESD comprenant un transistor bipolaire PNP et un transistor bipolaire NPN, formés sur une couche d'isolant enterrée épaisse. La base du transistor PNP est connectée au collecteur du transistor NPN. Le collecteur du transistor PNP est connecté à la base du transistor NPN. Un transistor MOS est formé sur le transistor NPN et connecté entre le collecteur et l'émetteur de ce transistor. Le transistor MOS permet de limiter la tension maximale aux bornes du dispositif ESD, permet de contrôler l'amplitude du courant de décharge et permet de limiter le courant de fuite.

Ce dispositif ESD présente cependant plusieurs inconvénients. Un circuit additionnel est nécessaire pour assurer le contrôle en courant de décharge par l'intermédiaire du transistor MOS, ce qui induit une baisse de densité d'intégration et une complexité accrue du circuit intégré. Par ailleurs, ce circuit présente une fiabilité détériorée, liée au dimensionnement de l'oxyde de grille du transistor MOS formé sur le transistor NPN. La présence du transistor MOS induit en outre une réduction d'épaisseur des transistors NPN et PNP, et par conséquent une augmentation de la résistance de conduction lors du déclenchement du dispositif ESD. Un tel dispositif ESD présente en outre une grande complexité d'interconnexion, et nécessite d'optimiser le dopage des bases, ce qui implique donc d'utiliser un grand nombre de masques de photolithographie.

Il existe un besoin pour un circuit intégré incluant un dispositif de protection contre les décharges électrostatiques résolvant un ou plusieurs de ces inconvénients. L'invention porte ainsi sur un circuit intégré comprenant un dispositif de protection contre les décharges électrostatiques, comprenant :
- une couche isolante enterrée comportant une épaisseur inférieure ou égale à 50nm ;
- des premiers et deuxième transistors bipolaires disposés sur la couche isolante enterrée, un de ces transistors bipolaires étant un transistor NPN, l'autre de ces transistors étant un transistor PNP, la base du premier transistor bipolaire étant confondue avec le collecteur du deuxième transistor bipolaire et la base du deuxième transistor bipolaire étant confondue avec le collecteur du premier transistor bipolaire, les premier et deuxième transistors bipolaires étant configurés pour conduire sélectivement un courant de décharge entre deux électrodes du dispositif de protection ;
- un premier plan de masse semi-conducteur disposé sous la couche isolante enterrée, adapté à être polarisé électriquement, s'étendant à l'aplomb de la base du premier transistor bipolaire, présentant un premier type de dopage identique à celui de la base du premier transistor bipolaire et présentant une densité de dopage au moins dix fois supérieure à celle de la base du premier transistor bipolaire.

Selon une variante, la densité de dopage dans la base du premier transistor bipolaire est inférieure ou égale à 10¹⁸cm⁻³.

Selon encore une variante, les bases des premier et deuxième transistors bipolaires sont formés dans une couche semi-conductrice présentant une épaisseur inférieure ou égale à 15nm.

Selon une autre variante, le circuit intégré comprend un deuxième plan de masse semi-conducteur disposé sous la couche d'isolant enterrée, polarisé électriquement, présentant un deuxième type de dopage et s'étendant à l'aplomb de la base du deuxième transistor bipolaire, lesdits premier et deuxième types de dopage étant différents.

Selon encore une autre variante, lesdits premiers et deuxième plans de masse sont en contact.

Selon une variante, les projections respectives des premier et deuxième plans de masse sur la couche isolante enterrée incluent les projections respectives des bases des premier et deuxième transistors bipolaires sur la couche isolante enterrée.

Selon encore une variante, le circuit intégré comprend en outre un élément isolant électriquement, cet élément séparant les premier et deuxième plans de masse et étant disposé à l'aplomb de la jonction entre la base du premier transistor bipolaire et la base du deuxième transistor bipolaire.

Selon une autre variante, ledit premier transistor bipolaire est dépourvu d'électrode en contact avec sa base.

Selon encore une autre variante, les faces supérieures des bases et des émetteurs desdits premier et deuxième transistors bipolaires sont affleurantes.

Selon une variante, le circuit intégré comprend en outre un transistor FDSOI formé sur ladite couche isolante enterrée et un plan de masse semi-conducteur disposé sous ladite couche isolante enterrée à l'aplomb dudit transistor FDSOI.

L'invention porte aussi sur un procédé de fabrication d'un circuit intégré comprenant un dispositif de protection contre les décharges électrostatiques, comprenant :
- l'implantation d'un premier type de dopage dans un substrat semi-conducteur disposé sous une couche isolante enterrée, la couche isolante enterrée présentant une épaisseur inférieure ou égale à 50nm, de façon à former un premier plan de masse ,
- la formation de premier et deuxième transistors bipolaires dont un transistor NPN et un transistor PNP sur la couche isolante enterrée, la base du premier transistor présentant le premier type de dopage et les bases respectives des premier et deuxième transistors bipolaires étant confondues avec les collecteurs respectifs des deuxième et premier transistors bipolaires, la base du premier transistor bipolaire étant formée à l'aplomb du premier plan de masse, le dopage de la base du premier transistor étant réalisé durant l'implantation du premier type de dopage de formation dudit premier plan de masse, la densité de dopage à l'issue de l'implantation dans le premier plan de masse étant au moins dix fois supérieure à celle de la base du premier transistor bipolaire.

Selon une variante, le procédé comprend des étapes de :
- formation d'une électrode connectée électriquement avec ledit premier plan de masse ;
- interconnexion de ladite électrode avec un circuit de polarisation.

Selon une autre variante, la densité de dopage dans la base du premier transistor après la formation de l'interconnexion avec le circuit de polarisation est inférieure ou égale à 10¹⁸cm⁻³.

Selon encore une variante, les premier et deuxième transistors bipolaires sont formés dans une couche semi-conductrice disposée sur ladite couche isolante enterrée, le procédé comprenant des étapes d'implantation de dopage dans la couche semi-conductrice, ces étapes d'implantation étant postérieures à l'implantation de formation dudit premier plan de masse, la base du premier transistor bipolaire étant masquée durant chacune de ces étapes d'implantation postérieures.

Selon encore une autre variante, le procédé de fabrication est dépourvu d'étape de formation d'une électrode en contact avec la base dudit premier transistor bipolaire.

D'autres caractéristiques et avantages de l'invention ressortiront clairement de la description qui en est faite ci-après, à titre indicatif et nullement limitatif, en référence aux dessins annexés, dans lesquels :
- la figure 1 est un exemple de diagramme tension/courant d'un dispositif ESD de l'état de la technique durant une décharge ;
- les figures 2 à 4 sont des vues en coupe transversales de différentes variantes d'un premier mode de réalisation d'un dispositif de protection contre les décharges électrostatiques selon l'invention ;
- la figure 5 est une vue de dessus schématique du dispositif de protection des figures 2 et 3 ;
- la figure 6 est un schéma électrique équivalent au dispositif de protection des figures 2 à 4 ;
- les figures 7 à 10 sont des vues en coupe transversales de différentes variantes d'un deuxième mode de réalisation d'un dispositif de protection contre les décharges électrostatiques selon l'invention ;
- la figure 11 est une vue en coupe transversale d'une première variante d'un troisième mode de réalisation d'un dispositif de protection contre les décharges électrostatiques selon l'invention ;
- la figure 12 est une vue de dessus du dispositif de la figure 11 ;
- la figure 13 est une vue en coupe transversale d'une deuxième variante d'un troisième mode de réalisation d'un dispositif de protection contre les décharges électrostatiques selon l'invention ;
- la figure 14 est une vue de dessus du dispositif de la figure 13 ;
- la figure 15 est une vue de dessus d'un ensemble de dispositifs selon la figure 11 accolés dans un circuit intégré ;
- les figures 16 à 17 sont des vues en coupe transversales de différentes variantes d'un quatrième mode de réalisation d'un dispositif de protection contre les décharges électrostatiques selon l'invention ;
- les figures 18 à 25 sont des vues en coupe transversales d'un circuit intégré selon la troisième variante du premier mode de réalisation de l'invention, durant différentes étapes d'un exemple de procédé de fabrication ;
- la figure 26 illustre des diagrammes de mesures de densités de courant en fonction de la tension d'anode, pour différentes tensions de polarisation de plans de masse.

L'invention propose un circuit intégré muni d'un dispositif de protection contre les décharges électrostatiques. Le dispositif de protection comprend des premiers et deuxième transistors bipolaires formés sur une couche isolante enterrée de type UTBOX dont l'épaisseur est inférieure ou égale à 50nm. Ces transistors sont configurés pour conduire sélectivement un courant de décharge entre deux électrodes du dispositif de protection. La base et le collecteur du premier transistor bipolaire sont confondus respectivement avec le collecteur et la base du deuxième transistor bipolaire. Ces transistors bipolaires sont configurés pour conduire sélectivement un courant de décharge entre deux électrodes du dispositif de protection.

Un premier plan de masse semi-conducteur (aussi couramment appelé grille arrière) est disposé sous la couche isolante enterrée et est polarisé électriquement. Le premier plan de masse est disposé à l'aplomb de la base du premier transistor bipolaire et présente un type de dopage identique à celui de cette base. La densité du dopage de ce premier plan de masse est au moins 10 fois supérieure à celle de la base du premier transistor bipolaire, avantageusement au moins 50 fois supérieure.

Un tel dispositif de protection contre les décharges électrostatiques permet de se dispenser d'une optimisation de la base d'un des transistors bipolaires, du fait du contrôle électrostatique de cette base par le premier plan de masse. Un tel dispositif de protection permet en outre d'utiliser un potentiel de polarisation du premier plan de masse relativement bas pour réaliser ce contrôle électrostatique.

Il s'avère qu'un tel dispositif de protection contre les décharges électrostatiques présente un courant de fuite très réduit, même en utilisant le ou les mêmes niveaux de polarisation des plans de masse que pour l'alimentation des autres circuits du circuit intégré. Par ailleurs, un tel dispositif de protection contre les décharges électrostatiques présente une résistance de conduction réduite et un courant maximal de décharge élevé, et ce sans nécessiter de circuit de contrôle complexe. Un tel circuit de protection contre les décharges électrostatiques peut également être réalisé sans induire une complexité excessive de ses interconnexions. Avec un procédé de fabrication approprié, on peut ainsi réduire le nombre de masques de photolithographie nécessaires, en réalisant la base du premier transistor bipolaire durant l'implantation du dopage du premier plan de masse.

La figure 2 est une vue en coupe transversale d'un circuit intégré 1, au niveau d'un dispositif de protection contre les décharges électrostatiques selon une première variante d'un premier mode de réalisation de l'invention. Le circuit intégré 1 comporte d'autres composants électroniques non illustrés ici.

Le dispositif de protection est formé à l'aplomb d'un substrat semi-conducteur 91. Ce substrat 91 a par exemple un dopage de type p. Le dispositif de protection comporte un transistor bipolaire de type NPN et un transistor bipolaire de type PNP.

Le transistor NPN comporte un émetteur 42, un collecteur 44 et une base 43. L'émetteur 42 inclut un élément semi-conducteur à dopage de type n, Le collecteur 44 comprend un élément semi-conducteur à dopage de type n, et la base 43 comprend un élément semi-conducteur à dopage de type p. Le transistor PNP comporte un émetteur 45. Cet émetteur 45 inclut un élément semi-conducteur à dopage de type p. La base du transistor PNP est confondue avec le collecteur 44 du transistor NPN (on la désignera donc par la suite par la référence 44), et le collecteur du transistor PNP est confondu avec la base 43 du transistor NPN, un thyristor étant ainsi formé. Les émetteurs 42 et 45 présentent avantageusement des dopages respectifs N+ et P+. Les émetteurs 42 et 45 et les bases 43 et 44 sont formés dans une couche semi-conductrice (ici en silicium) disposée sur une couche isolante enterrée 2 présentant une épaisseur inférieure ou égale à 50 nm. Par isolation, on entendra dans la présente description une isolation électrique. Les transistors NPN et PNP sont avantageusement coplanaires. Par coplanaire, on entend que l'on peut définir un plan traversant les émetteurs, bases et collecteurs de ces transistors, ce plan étant parallèle à la couche isolante enterrée 2. La couche semi-conductrice présente typiquement une épaisseur inférieure ou égale à 15nm, de préférence inférieure à 10nm, et avantageusement inférieure ou égale à 7nm. Une telle épaisseur de couche semi-conductrice facilite le contrôle électrostatique des bases 43 et 44 par des plans de masse 93 et 94. Ces épaisseurs correspondent typiquement à l'épaisseur d'une couche semi-conductrice sur la couche isolante enterrée 2 avant une reprise d'épitaxie.

Les émetteurs 42 et 45 sont connectés respectivement à des électrodes K et A du dispositif de protection contre les décharges électrostatiques. Des contacts métalliques 32 et 33 sont à cet effet en contact avec les émetteurs 42 et 45 respectivement. Les transistors NPN et PNP sont ainsi configurés pour conduire sélectivement un courant de décharge entre les électrodes K et A, comme détaillé par la suite.

Le dispositif de protection contre les décharges électrostatiques comprend en outre un premier plan de masse semi-conducteur 93 et un deuxième plan de masse semi-conducteur 94. Les premier et deuxième plans de masse 93 et 94 sont disposés sous la couche isolante enterrée 2. Le premier plan de masse 93 s'étend jusqu'à l'aplomb de la base 43. Le premier plan de masse 93 présente un dopage de type identique à celui de la base 43, donc un dopage de type p. Le deuxième plan de masse 94 s'étend jusqu'à l'aplomb de la base 44. Le deuxième plan de masse 94 présente un dopage de type identique à celui de la base 43, donc un dopage de type n. Les plans de masse 93 et 94 sont polarisés électriquement. La polarisation électrique du plan de masse 93 est appliquée par l'intermédiaire d'une zone implantée 41 à dopage de type p (et avantageusement à dopage de type P+) et par l'intermédiaire d'un contact métallique 31. Une polarisation Gp est appliquée sur le contact métallique 31 par l'intermédiaire d'un circuit de polarisation non illustré ici. La polarisation électrique du plan de masse 94 est appliquée par l'intermédiaire d'une zone implantée 46 à dopage de type n (et avantageusement à dopage de type N+) et par l'intermédiaire d'un contact métallique 34. Une polarisation Gn est appliquée sur le contact métallique 34 par l'intermédiaire du circuit de polarisation.

Le dispositif de protection contre les décharges électrostatiques comporte avantageusement à sa périphérie des tranchées d'isolation 61 et 64 s'étendant en profondeur jusqu'au substrat 91. Le dispositif de protection comporte en outre avantageusement une tranchée d'isolation 62 séparant l'émetteur 42 de la zone implantée 41. La tranchée d'isolation 62 s'étend en profondeur jusqu'à la couche isolante enterrée 2. Le dispositif de protection comporte en outre avantageusement une tranchée d'isolation 63 séparant l'émetteur 45 de la zone implantée 46. La tranchée d'isolation 63 s'étend en profondeur jusqu'à la couche isolante enterrée 2. Dans cette variante, les tranchées d'isolation 61 et 64 s'étendent plus profondément que les tranchées d'isolation 62 et 63. Les plans de masse 93 et 94 s'étendent respectivement sous les tranchées d'isolation 62 et 63, jusqu'en contact respectivement avec les zones implantées 41 et 46. L'utilisation de tranchées d'isolation de profondeurs différentes permet de diminuer le nombre d'étapes d'implantation, la polarisation des plans de masse 93 et 94 par des électrodes nécessitant alors un moins grand nombre d'étapes d'implantation.

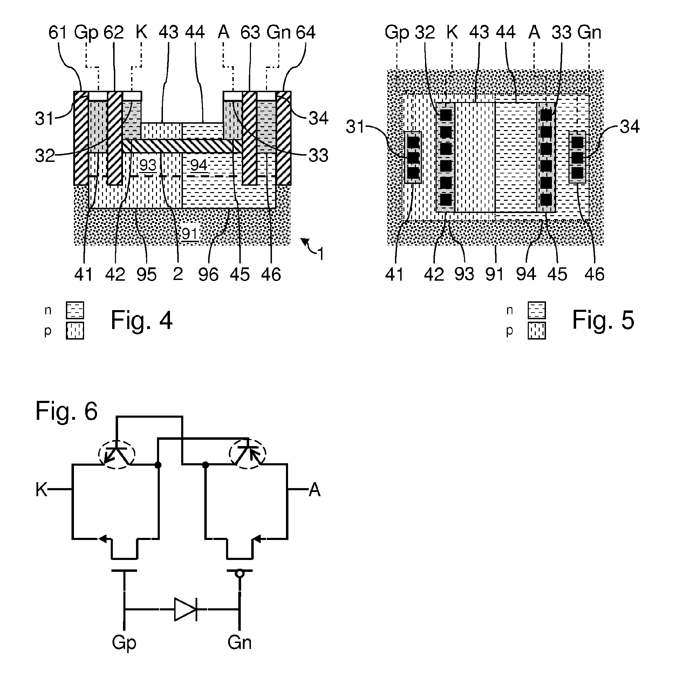

La figure 5 est une vue de dessus du dispositif de protection contre les décharges électrostatiques. Dans un souci de lisibilité, les tranchées d'isolation 61 à 64 n'ont pas été illustrées.

La densité de dopage des bases 43 et 44 est au moins dix fois inférieure à la densité de dopage des plans de masse 93 et 94 respectivement. Un tel dopage peut être obtenu lors des implantations respectives des plans de masse 93 et 94. Ainsi, lors d'une implantation d'un plan de masse, avec une profondeur d'implantation maximale disposée sous la couche d'isolant enterrée 2, la densité de dopage de même type dans le semi-conducteur disposé sur la couche isolante enterrée 2 est suffisante pour former une base d'un transistor bipolaire. Plus le dopage résiduel des bases 43 et 44 à l'issue de cette implantation est faible, plus on peut appliquer des niveaux de tension de polarisation faibles sur les plans de masse 93 et 94. Le dopage des bases 43 et 44 présente typiquement une densité inférieure à 10¹⁸cm⁻³, de préférence inférieure à 5*10¹⁷cm⁻³. Pour accroître l'influence du contrôle électrostatique d'un plan de masse sur la base disposée à son aplomb, la couche isolante enterrée présente avantageusement une épaisseur inférieure ou égale à 25 nm, voire inférieur ou égale à 15 nm.

Dans cette variante, la face supérieure des bases 43 et 44 est en retrait par rapport à la face supérieure des émetteurs 42 et 45. La formation des émetteurs 42 et 45 peut par exemple être poursuivie lors d'une phase de reprise d'épitaxie pour former des émetteurs 42 et 45 plus hauts que les bases 43 et 44.

La figure 6 est une approximation du schéma électrique équivalent au dispositif de protection contre les décharges électrostatiques du premier mode de réalisation.

Les polarisations respectives appliquées sur les plans de masse 93 et 94 permettent d'assurer un contrôle électrostatique des bases 43 et 44. Ce contrôle électrostatique permet d'une part de réduire le courant de fuite lorsque le dispositif de protection n'est pas activé et aussi de moduler les tensions de déclenchement respectives des transistors NPN et PNP lors d'une décharge électrostatique, en particulier en l'absence d'électrode de commande d'une ou des deux bases 43 et 44.

Dans un premier mode de fonctionnement correspondant au mode de protection contre les décharges électrostatiques, le circuit de polarisation peut appliquer une tension Gnd sur le plan de masse 93 et sur le plan de masse 94, en particulier lorsque le dopage des bases 43 et 44 est inférieur à 10¹⁸cm⁻³. Le déclenchement des transistors NPN et PNP n'est alors pas bloqué pour permettre un déclenchement en présence d'une décharge électrostatique. On peut ajuster la tension de seuil de déclenchement en modifiant l'amplitude d'une valeur Vp et en appliquant -Vp sur le plan de masse 93 et +Vp sur le plan de masse 94. Plus la valeur de Vp est élevée, plus on relève la tension de déclenchement des transistors NPN et PNP. Du fait du contrôle électrostatique obtenu avec les plans de masse 93 et 94, la tension de déclenchement peut être fixée en utilisant une faible valeur de Vp, typiquement inférieure ou égale à une tension Vdd d'alimentation de circuits logiques ou mémoire du circuit intégré 1. On peut également appliquer une tension Gnd sur le plan de masse 93 et une tension +Vp sur le plan de masse 94. On peut encore appliquer une tension Vp1 négative sur le plan de masse 93 et une tension Vp2 positive sur le plan de masse 94, avec des amplitudes différentes pour Vp1 et Vp2. Le comportement du dispositif de protection lors de l'apparition d'une décharge électrostatique peut donc aisément être ajusté.

Dans un second mode de fonctionnement correspondant au mode de fonctionnement normal du circuit intégré, le circuit de polarisation peut appliquer la tension -Vdd sur le plan de masse 93 et la tension Vdd sur le plan de masse 94, Vdd étant par exemple égal à 1 V. Ainsi, malgré le très faible dopage des bases 43 et 44, un courant de fuite très faible les traverse en fonctionnement normal du circuit intégré 1. Le dopage des porteurs majoritaires dans les bases 43 et 44 pourra cependant être défini suffisamment élevé (par exemple proche de 10¹⁸cm⁻³) pour réduire le courant de fuite les traversant avec des niveaux de polarisation des plans de masse encore plus bas.

La figure 3 est une vue en coupe transversale d'une deuxième variante de dispositif de protection contre les décharges électrostatiques du premier mode de réalisation. Cette variante reprend l'ensemble des caractéristiques de la première variante, la seule différence étant que les faces supérieures des bases 43 et 44 sont affleurantes avec les faces supérieures des émetteurs 42 et 45. La formation des bases 43 et 44 et des émetteurs 42 et 45 peut par exemple être poursuivie lors d'une même phase de reprise d'épitaxie. Une telle variante permet de réduire au maximum la résistance de conduction à travers les bases 43 et 44 et ainsi d'augmenter l'intensité maximale de court-circuit lors d'une décharge électrostatique. L'épaisseur des bases 43 et 44 issues d'une reprise d'épitaxie est avantageusement inférieure ou égale à 25 nm, et de préférence inférieure ou égale à 22 nm, afin de conserver un contrôle électrostatique des bases 43 et 44 optimal par les plans de masse 93 et 94.

Avantageusement, une étape de recuit permet de diffuser les dopants de chacune des bases 43 et 44 dans leur partie supérieure obtenue par épitaxie.

La figure 4 est une vue en coupe transversale d'une troisième variante de dispositif de protection contre les décharges électrostatiques du premier mode de réalisation. Cette variante reprend l'ensemble des caractéristiques de la première variante, les tranchées d'isolation 62 et 63 s'étendant plus profondément que les plans de masse 93 et 94, jusqu'à la même profondeur que les tranchées d'isolation 61 et 64. Dans cette variante :
- un caisson 95 est en outre formé dans le substrat 91 à l'aplomb du plan de masse 93. Le caisson 95 s'étend sous la tranchée d'isolation 62. Le caisson 95 forme un élément semi-conducteur à dopage de type p reliant le plan de masse 93 à la zone implantée 41 ;
- un caisson 96 est en outre formé dans le substrat 91 à l'aplomb du plan de masse 94. Le caisson 96 s'étend sous la tranchée d'isolation 63. Le caisson 96 forme un élément semi-conducteur à dopage de type n reliant le plan de masse 94 à la zone implantée 46.

Selon le premier mode de réalisation, les plans de masse 93 et 94 sont en contact. Pour éviter une conduction en direct de la diode formée entre les plans de masse 93 et 94, la tension de polarisation Gp est au plus égale à la tension de polarisation Gn. Selon ce premier mode de réalisation, les plans de masse 93 et 94 ont des projections respectives (selon la normale à la couche isolante enterrée) sur la couche isolante enterrée 2 qui incluent les projections respectives des bases 43 et 44 sur cette couche isolante enterrée. On maximise ainsi le contrôle électrostatique des plans de masse 93 et 94 sur les bases 43 et 44.

Dans les différentes variantes illustrées du premier mode de réalisation, les bases 43 et 44 sont dépourvues de contact métallique ou de contact d'électrode.

Avantageusement, la concentration de dopants des émetteurs 42 et 45 est au moins égale à 10²⁰cm⁻³, de préférence, au moins égale à 5*10²⁰cm⁻³, et avantageusement au moins égale à 10²¹cm⁻³. Avantageusement, la concentration de dopants des bases 43 et 44 est comprise entre à 5*10¹⁶cm⁻³ et 5*10¹⁷cm⁻³.

Les autres composants électroniques du circuit intégré 1 peuvent par exemple comprendre des transistors de type FDSOI, disposés sur la même couche isolante enterrée 2 que le dispositif de protection. Ces transistors FDSOI peuvent être disposés à l'aplomb de plans de masse polarisés respectifs disposés sous la couche isolante enterrée 2. Dans cette technologie, le dopage du canal du transistor est quasiment nul (typiquement de 10¹⁵ cm⁻³).

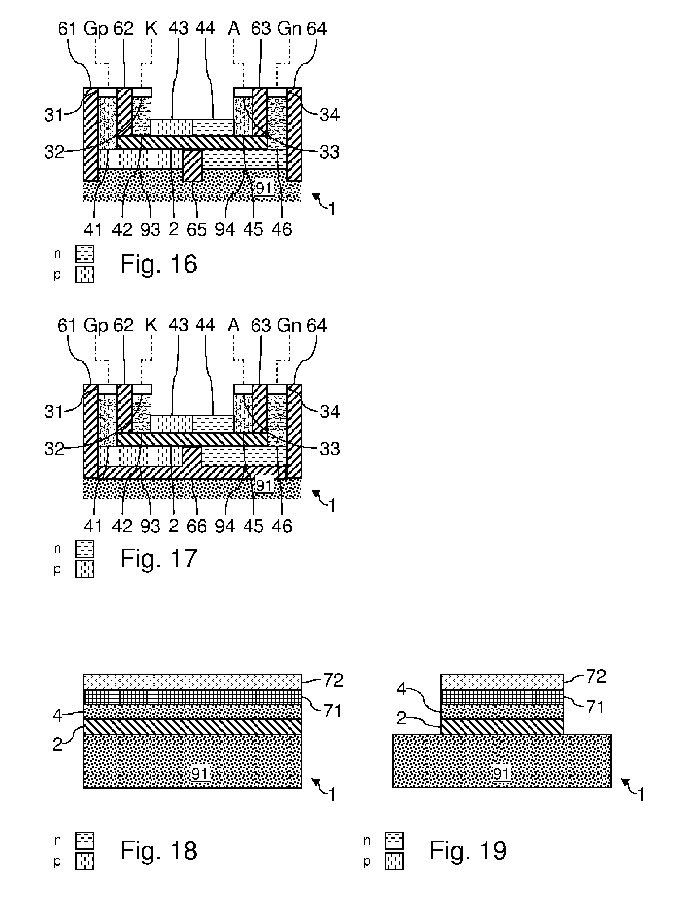

Les figures 18 à 25 sont des vues en coupe transversales d'un circuit intégré 1 selon la troisième variante du premier mode de réalisation de l'invention, durant différentes étapes d'un exemple de procédé de fabrication.

À la figure 18, on dispose d'une couche isolante enterrée 2 disposée sur un substrat semi-conducteur 91 (typiquement en silicium). Une couche semi conductrice 4 (typiquement une couche de silicium fine présentant une épaisseur inférieure ou égale à 10 nm, voire inférieure ou égale à 7 nm) est disposée sur la couche isolante enterrée 2. Un masque dur d'oxyde 71 est typiquement formé sur la couche 4. Le masque dur 71 présente une composition et une épaisseur connues en soi. Une couche de nitrure 72 est typiquement formée sur le masque dur 71. La couche de nitrure 72 présente une composition et une épaisseur connues en soi.

À la figure 19, on met en forme le circuit intégré 1 par photolithographie de façon à maintenir le nitrure 72, le masque dur 71, la couche 4 et la couche isolante 2 dans la zone dans laquelle on souhaite former les transistors NPN et PNP du dispositif de protection. Les couches de nitrure 72 et de masque dur 71 sont retirées notamment dans les zones où l'on souhaite former des transistors de type Bulk en retirant la couche isolante enterrée 2.

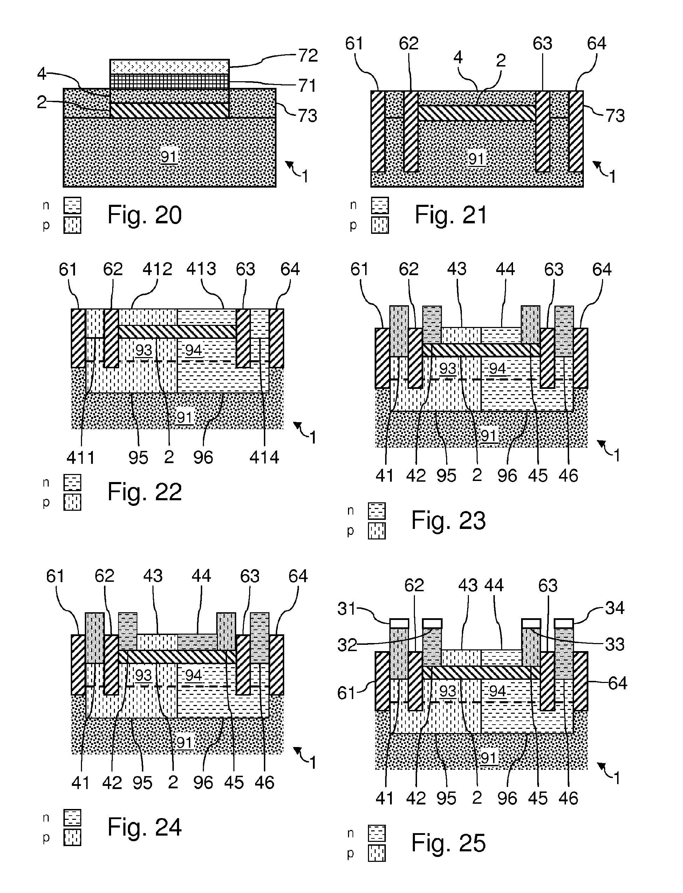

À la figure 20, on réalise de façon avantageuse une épitaxie pour les éventuelles zones Bulk du circuit intégré 1. L'épitaxie est par exemple réalisée pour former une couche semi conductrice de silicium 73 affleurante avec la couche 4.

À la figure 21, on a retiré le masque dur 71 et la couche de nitrure 72. Des tranchées d'isolation 62 et 63 sont formées et s'étendent jusque dans le substrat 91 à la périphérie de la couche 4. Des tranchées d'isolation 61 et 64 sont formées et s'étendent jusque dans le substrat 91. Les tranchées d'isolation 61 et 64 présentent dans cette variante une même profondeur que les tranchées d'isolation 62 et 63. Un élément semi-conducteur s'étend entre les tranchées d'isolation 61 et 62 jusqu'au substrat 91. Un élément semi-conducteur s'étend entre les tranchées d'isolation 63 et 64 jusqu'au substrat 91. Les matériaux (par exemple de l'oxyde de silicium) et les profondeurs des tranchées d'isolation 61 à 64 sont connus en soi.

En variante de la séquence des étapes 18 à 21, on peut procéder comme suit :
On dispose d'une couche isolante enterrée 2 disposée sur un substrat semi-conducteur 91. Une couche semi conductrice 4 est disposée sur la couche isolante enterrée 2.

Des tranchées d'isolation 62 et 63 sont formées et s'étendent jusque dans le substrat 91 à la périphérie de la couche 4. Des tranchées d'isolation 61 et 64 sont formées et s'étendent jusque dans le substrat 91. Les tranchées d'isolation 61 et 64 présentent dans cette variante une même profondeur que les tranchées d'isolation 62 et 63. Un élément semi-conducteur s'étend entre les tranchées d'isolation 61 et 62 jusqu'au substrat 91. Un élément semi-conducteur s'étend entre les tranchées d'isolation 63 et 64 jusqu'au substrat 91. Les matériaux (par exemple de l'oxyde de silicium) et les profondeurs des tranchées d'isolation 61 à 64 sont connus en soi.

Un masque dur d'oxyde 71 est ensuite formé sur la couche 4. Une couche de nitrure 72 est ensuite formée sur le masque dur 71.

On met ensuite en forme le circuit intégré 1 par photolithographie de façon à maintenir le nitrure 72, le masque dur 71, la couche 4 et la couche isolante 2 dans la zone dans laquelle on souhaite former les transistors NPN et PNP du dispositif de protection. Les couches de nitrure 72 et de masque dur 71 sont retirées notamment dans les zones où l'on souhaite former des transistors de type Bulk en retirant la couche isolante enterrée 2.

Optionnellement, on réalise une épitaxie pour les éventuelles zones Bulk du circuit intégré 1. L'épitaxie est par exemple réalisée pour former une couche semi conductrice de silicium 73 affleurante avec la couche 4.

À la figure 22, on a réalisé l'implantation d'un plan de masse 93 à dopage de type p sous la couche isolante enterrée 2 d'une part, et l'implantation d'un plan de masse 94 à dopage de type n sous la couche isolante enterrée 2. L'implantation du plan de masse 93 est typiquement réalisée avec une dose comprise entre 10¹² cm⁻² et 10¹⁴ cm⁻² d'Indium, et une énergie comprise entre 110 et 180 keV. L'implantation du plan de masse 94 est typiquement réalisée avec une dose comprise entre 10¹² cm⁻² et 10¹⁴ cm⁻² d'Arsenic, et une énergie comprise entre 90 et 150 keV. Les énergies d'implantation seront bien entendues ajustées en fonction de l'épaisseur de la couche 2 et du film 4.

Par ailleurs, un caisson 95 à dopage de type p a été implanté sous le plan de masse 93 et s'étend sous la tranchée d'isolation 62 jusque dans l'élément semi-conducteur disposé entre les tranchées d'isolation 61 et 62. Un caisson 96 à dopage de type n a été implanté sous le plan de masse 94 et s'étend sous la tranchée d'isolation 63 jusque dans l'élément semi-conducteur disposé entre les tranchées d'isolation 63 et 64.

Bien que l'implantation du plan de masse 93 soit configurée pour présenter une densité maximale d'implantation sous la couche isolante enterrée 2 et dans ce plan de masse 93, cette implantation induit également un dopage de type p dans la couche 4 à l'aplomb du plan de masse 93 (zone 412) et dans la partie supérieure de l'élément semi-conducteur présent entre les tranchées d'isolation 61 et 62.

De même, bien que l'implantation du plan de masse 94 soit configurée pour présenter une densité maximale d'implantation sous la couche isolante enterrée 2 et dans ce plan de masse 94, cette implantation induit également un dopage de type n dans la couche 4 à l'aplomb du plan de masse 94 (zone 413) et dans la partie supérieure de l'élément semi-conducteur présent entre les tranchées d'isolation 63 et 64.

À la figure 23, on a réalisé une reprise d'épitaxie pour faire croître l'épaisseur de silicium sur l'élément semi-conducteur présent entre les tranchées d'isolation 61 et 62, sur l'élément semi-conducteur présent entre les tranchées d'isolation 63 et 64, sur une partie de la zone 412 en contact avec la tranchée 62, et sur une partie de la zone 413 en contact avec la tranchée 63. Les zones sur lesquelles on ne souhaite pas réaliser d'épitaxie sont typiquement protégées par un masque dur (non illustré). Une zone implantée 41 est formée par dopage de type P+, l'émetteur 42 est formé par dopage de type N+, l'émetteur 45 est formé par dopage de type P+ et la zone implantée 46 est formée par dopage de type N+.

À l'issue des étapes illustrées à la figure 23, on dispose ainsi :
- d'une base 43 ayant le même type de dopage que le plan de masse 93, mais avec une densité de dopage au moins 10 fois inférieure ;
- d'une base 44 ayant le même type de dopage que le plan de masse 94 et avec une densité de dopage au moins 10 fois inférieure.

On dispose ainsi de la structure des transistors bipolaires NPN et PNP et du thyristor correspondant. Pour la suite du procédé, on conserve le dopage d'au moins d'une des bases formées durant l'implantation d'un des plans de masse. Le dopage d'au moins une des deux bases est donc réalisé durant l'implantation de son plan de masse. Le dopage résiduel de cette base à l'issue de l'implantation de son plan de masse présente typiquement une densité inférieure à 10¹⁸cm⁻³, de préférence inférieure à 5*10¹⁷cm⁻³. Ainsi, au moins une des deux bases ne fait plus l'objet d'une implantation, en maintenant par exemple au moins une de ces deux bases masquée lors de toute étape ultérieure d'implantation.

À la figure 25, en partant de la structure obtenue à la figure 23:
- on a défini un masque de protection en définissant les emplacements des contacts métalliques de polarisation ;
- on a procédé à une siliciuration ;
- on a déposé du métal pour former des contacts métalliques 31 à 34 respectivement sur la zone implantée 41, l'émetteur 42, l'émetteur 45 et la zone implantée 46 ;
- on a retiré le masque de protection.

Lors d'étapes ultérieures, on réalise des interconnexions avec les contacts métalliques 31 à 34. Par exemple, les contacts métalliques 31 et 34 sont connectés à un circuit de polarisation. À ce stade, le dopage dans les bases 43 et 44 correspond encore au dopage à l'issue de l'implantation des plans de masse 93 et 94.

On peut constater que les avantages d'un circuit intégré 1 obtenu selon un tel procédé de fabrication n'induisaient pas nécessairement une complexification du procédé de fabrication. En effet, un tel procédé de fabrication permet d'utiliser un même masque pour l'implantation de dopants dans une base et dans un plan de masse.

À la figure 24, on a illustré une variante dans laquelle la base 44 de la structure obtenue à la figure 23 fait l'objet d'une implantation additionnelle de type LDD (pour lowly doped drain en langue anglaise, pour un dopage typiquement compris entre 10¹⁸cm⁻³ et 10¹⁹cm⁻³).

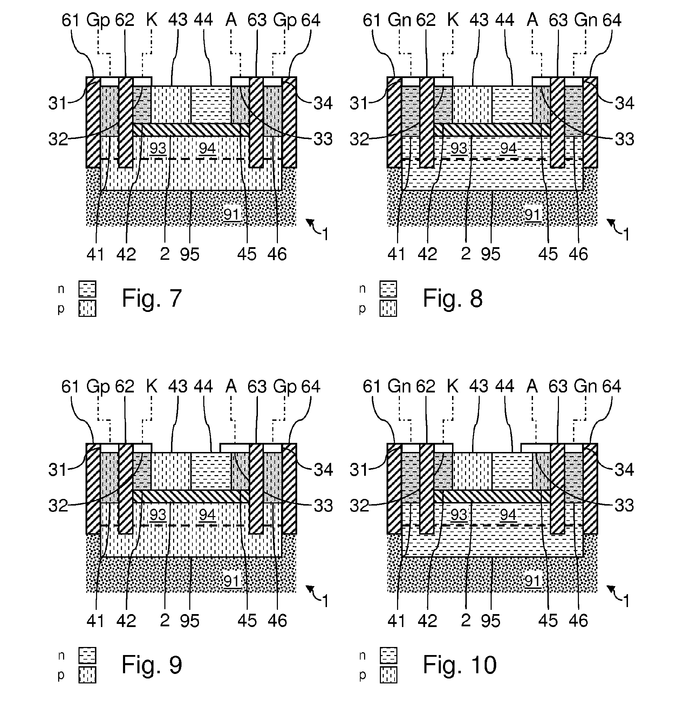

La figure 7 est une vue en coupe transversale d'un circuit intégré 1, au niveau d'un dispositif de protection contre les décharges électrostatiques selon une première variante d'un deuxième mode de réalisation de l'invention. Le circuit intégré 1 comporte d'autres composants électroniques non illustrés ici.

Cette variante reprend l'ensemble des caractéristiques de la troisième variante du premier mode de réalisation, les principales différences étant que :
- les plans de masse 93 et 94 sont confondus en un élément semi-conducteur à dopage de type p s'étendant sous les bases 43 et 44 et sous les émetteurs 42 et 45 ;
- les caissons 95 et 96 sont remplacés par un caisson 95 continu à dopage de type p s'étendant sous les plans de masse 93 et 94, et sous les tranchées d'isolation 62 et 63 jusque dans les éléments semi-conducteur disposés respectivement entre les tranchées d'isolation 61 et 62 et entre les tranchées d'isolation 63 et 64.

La densité de dopage de la base 43 est au moins 10 fois inférieure à la densité de dopage du plan de masse 93. La densité de dopage de la base 44 peut également être au moins 10 fois inférieure à la densité de dopage du plan de masse 94. Le dopage de la base 43 étant de même type que celui du plan de masse 93, son dopage peut être obtenu lors de l'implantation du plan de masse 93. Ainsi, lors de l'implantation du plan de masse 93, avec une profondeur d'implantation maximale disposée sous la couche d'isolant enterrée 2, la densité de dopage de même type dans le semi-conducteur disposé sur la couche d'isolant enterrée 2 est suffisante pour former la base 43.

Le dopage de la base 44 étant d'un type opposé à celui du plan de masse 94, la base 44 fait l'objet d'une implantation à dopage de type n postérieure à l'implantation des plans de masse 93 et 94. Le dopage de la base 44 peut typiquement être un dopage de type LDD. La densité de dopage de la base 44 est alors typiquement supérieure à la densité de dopage de la base 43.

Le deuxième mode de réalisation permet de réaliser les plans de masse 93 et 94 durant une même étape d'implantation. Par ailleurs, le procédé de fabrication et la commande du dispositif de protection sont simplifiés, puisqu'une même tension de polarisation est appliquée sur les plans de masse 93 et 94, de préférence avec de même contact métallique.

Dans cette variante du deuxième mode de réalisation, le contrôle électrostatique de la base 43 par le plan de masse 93 est prépondérant par rapport au contrôle électrostatique de la base 44 par le plan de masse 94.

La figure 8 est une vue en coupe transversale d'une deuxième variante de dispositif de protection contre les décharges électrostatiques du deuxième mode de réalisation. Cette variante reprend l'ensemble des caractéristiques de la première variante, les principales différences étant que :
- les plans de masse 93 et 94 sont confondus en un élément semi-conducteur à dopage de type n s'étendant sous les bases 43 et 44 et sous les émetteurs 42 et 45 ;
- le caisson 95 est remplacé par un caisson 95 continu à dopage de type n s'étendant sous les plans de masse 93 et 94, et sous les tranchées d'isolation 62 et 63 jusque dans les éléments semi-conducteur disposés respectivement entre les tranchées d'isolation 61 et 62 et entre les tranchées d'isolation 63 et 64.

La densité de dopage de la base 44 est au moins 10 fois inférieure à la densité de dopage du plan de masse 94. La densité de dopage de la base 43 peut également être au moins 10 fois inférieure à la densité de dopage du plan de masse 93. Le dopage de la base 44 étant de même type que celui du plan de masse 94, son dopage peut être obtenu lors de l'implantation du plan de masse 94. Ainsi, lors de l'implantation du plan de masse 94, avec une profondeur d'implantation maximale disposée sous la couche d'isolant enterrée 2, la densité de dopage de même type dans le semi-conducteur disposé sur la couche d'isolant enterrée 2 est suffisante pour former la base 44.

Le dopage de la base 43 étant d'un type opposé à celui du plan de masse 93, la base 43 fait l'objet d'une implantation à dopage de type p postérieure à l'implantation des plans de masse 93 et 94. Le dopage de la base 43 peut typiquement être un dopage de type LDD. La densité de dopage de la base 43 est alors typiquement supérieure à la densité de dopage de la base 44.

Dans cette variante du deuxième mode de réalisation, le contrôle électrostatique de la base 44 par le plan de masse 94 est prépondérant par rapport au contrôle électrostatique de la base 43 par le plan de masse 93.

La figure 9 est une vue en coupe transversale d'une troisième variante de dispositif de protection contre les décharges électrostatiques du deuxième mode de réalisation. Cette variante reprend l'ensemble des caractéristiques de la première variante, l'unique différence étant que le contact métallique 33 s'étend jusqu'à l'aplomb de la base 44, en contact avec cette base 44. Comme dans la première variante du premier mode de réalisation, la base 43 est dépourvue de contact métallique. Dans cette variante, on améliore le contrôle de la base 44, on modifie le gain du transistor PNP (en l'abaissant), et ce sans accroître l'encombrement du circuit intégré 1 ni accroître la complexité de son procédé de fabrication.

Quelle que soit la forme du contact métallique 33, on peut également envisager que le contact métallique 32 s'étend jusqu'à l'aplomb de la base 43, en contact avec cette base 43.

La figure 10 est une vue en coupe transversale d'une quatrième variante de dispositif de protection contre les décharges électrostatiques du deuxième mode de réalisation. Cette variante reprend l'ensemble des caractéristiques de la troisième variante, l'unique différence étant que le contact métallique 33 s'étend jusqu'à l'aplomb de la base 44, en contact avec cette base 44. Comme dans la troisième variante du premier mode de réalisation, la base 43 est dépourvue de contact métallique. Dans cette variante, on améliore le contrôle de la base 44, on modifie le gain du transistor PNP, et ce sans accroître l'encombrement du circuit intégré 1 ni accroître la complexité de son procédé de fabrication.

Quelle que soit la forme du contact métallique 33, on peut également envisager que le contact métallique 32 s'étend jusqu'à l'aplomb de la base 43, en contact avec cette base 43.

On peut également prévoir d'autres variantes à partir des première et deuxième variantes du deuxième mode de réalisation. En partant des première et deuxième variantes, on peut prévoir que le contact métallique 32 s'étend jusqu'à l'aplomb de la base 43, en contact avec cette base 43. La base 44 est alors dépourvue de contact métallique.

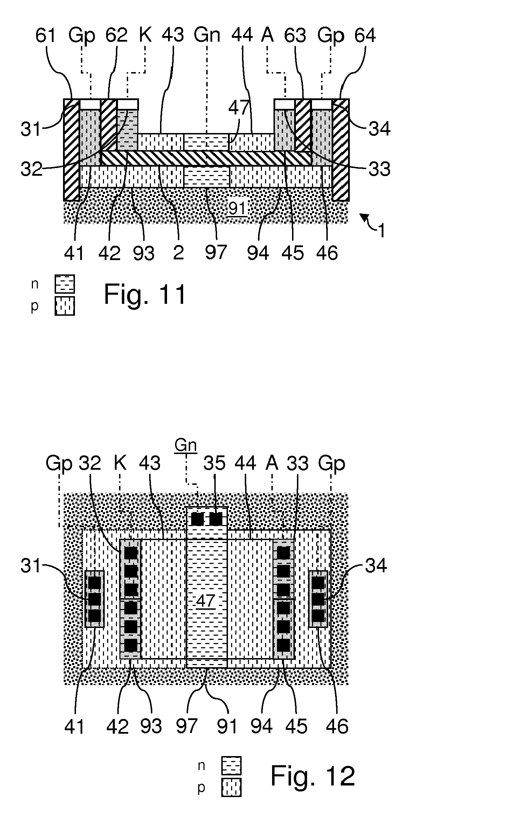

La figure 11 est une vue en coupe transversale d'une première variante d'un dispositif de protection contre les décharges électrostatiques selon un troisième mode de réalisation. Le troisième mode de réalisation est destiné à former un TRIAC (pour Triode for Alternating Current en langue anglaise) afin de protéger le circuit intégré quel que soit le sens d'écoulement de la décharge électrostatique. On obtient ainsi une protection bidirectionnelle du circuit intégré 1. Le circuit intégré 1 comporte d'autres composants électroniques non illustrés ici.

Le dispositif de protection est formé à l'aplomb d'un substrat semi-conducteur 91. Ce substrat 91 a par exemple un dopage de type p. Le dispositif de protection comporte un transistor bipolaire de type NPN et un transistor bipolaire de type PNP pour former un TRIAC.

Le transistor NPN comporte un émetteur 42, un collecteur 47 et une base 43. L'émetteur 42 inclut un élément semi-conducteur à dopage de type n, Le collecteur 47 comprend un élément semi-conducteur à dopage de type n, et la base 43 comprend un élément semi-conducteur à dopage de type p. Le transistor PNP comporte un émetteur. Cet émetteur inclut un élément premier élément semi-conducteur 45 à dopage de type p et un deuxième élément semi-conducteur 44 à dopage de type p. La base du transistor PNP est confondue avec le collecteur 47 du transistor NPN (on la désignera donc par la suite par la référence 47), et le collecteur du transistor PNP est confondu avec la base 43 du transistor NPN. L'émetteur 42 et le premier élément semi-conducteur 45 présentent avantageusement des dopages respectifs N+ et P+. Les émetteurs 42 et 44/45 et les bases 43 et 47 sont formés dans une couche semi-conductrice (ici en silicium) disposée sur une couche isolante enterrée 2 présentant une épaisseur inférieure ou égale à 50 nm. Les transistors NPN et PNP sont avantageusement coplanaires. La couche semi-conductrice présente typiquement une épaisseur inférieure ou égale à 15nm, de préférence inférieure à 10nm, et avantageusement inférieure ou égale à 7nm. Une telle épaisseur de couche semi-conductrice facilite le contrôle électrostatique des bases 43 et 47 par des plans de masse 93 et 97. Ces épaisseurs correspondent typiquement à l'épaisseur d'une couche semi-conductrice sur la couche isolante enterrée 2 avant une reprise d'épitaxie.

Les émetteurs des transistors NPN et PNP sont connectés respectivement à des électrodes K et A du dispositif de protection contre les décharges électrostatiques. Des contacts métalliques 32 et 33 sont à cet effet en contact avec les émetteurs des transistors NPN et PNP respectivement. Les transistors NPN et PNP sont ainsi configurés pour conduire sélectivement un courant de décharge entre les électrodes K et A.

Le dispositif de protection contre les décharges électrostatiques comprend en outre un premier plan de masse semi-conducteur 93, un deuxième plan de masse semi-conducteur 94 et un troisième plan de masse semi-conducteur 97.

Les premier, deuxième et troisième plans de masse 93, 94 et 97 sont disposés sous la couche isolante enterrée 2. Le premier plan de masse 93 s'étend jusqu'à l'aplomb de la base 43. Le premier plan de masse 93 présente un dopage de type identique à celui de la base 43, donc un dopage de type p. Le troisième plan de masse 97 présente un dopage de type identique à celui de la base 47, donc un dopage de type n.

Le deuxième plan de masse 94 s'étend à l'aplomb de l'émetteur incluant les éléments semi-conducteurs 44 et 45. Le deuxième plan de masse 94 présente un dopage de type identique à celui de ces éléments semi-conducteurs 44 et 45, donc un dopage de type p. Les plans de masse 93, 94 et 97 sont polarisés électriquement. La polarisation électrique du plan de masse 93 est appliquée par l'intermédiaire d'une zone implantée 41 à dopage de type p (et avantageusement à dopage de type P+) et par l'intermédiaire d'un contact métallique 31. Une polarisation Gp est appliquée sur le contact métallique 31 par l'intermédiaire d'un circuit de polarisation non illustré ici. La polarisation électrique du plan de masse 94 est appliquée par l'intermédiaire d'une zone implantée 46 à dopage de type p (et avantageusement à dopage de type P+) et par l'intermédiaire d'un contact métallique 34. La polarisation Gp est appliquée sur le contact métallique 34. La polarisation électrique du plan de masse 97 est appliquée par l'intermédiaire d'une zone implantée non illustrée à dopage de type n (et avantageusement à dopage de type N+) et par l'intermédiaire d'un contact métallique 35. Une polarisation Gn est appliquée sur le contact métallique 35 par l'intermédiaire du circuit de polarisation.

Ce dispositif de protection contre les décharges électrostatiques comporte avantageusement à sa périphérie des tranchées d'isolation 61 et 64 s'étendant en profondeur jusqu'au substrat 91. Le dispositif de protection comporte en outre avantageusement une tranchée d'isolation 62 séparant l'émetteur 42 de la zone implantée 41. La tranchée d'isolation 62 s'étend en profondeur jusqu'à la couche isolante enterrée 2. Le dispositif de protection comporte en outre avantageusement une tranchée d'isolation 63 séparant l'émetteur du transistor PNP de la zone implantée 46. La tranchée d'isolation 63 s'étend en profondeur jusqu'à la couche isolante enterrée 2. Dans cette variante, les tranchées d'isolation 61 et 64 s'étendent plus profondément que les tranchées d'isolation 62 et 63.

Les plans de masse 93 et 94 s'étendent respectivement sous les tranchées d'isolation 62 et 63, jusqu'en contact respectivement avec les zones implantées 41 et 46. Le plan de masse 97 s'étend selon un autre axe sous une tranchée d'isolation non illustrée, jusqu'en contact avec une zone implantée.

La figure 12 est une vue de dessus du dispositif de protection contre les décharges électrostatiques de la figure 11. Dans un souci de lisibilité, les tranchées d'isolation 61 à 64 n'ont pas été illustrées.

La densité de dopage des bases 43 et 47 est au moins dix fois inférieure à la densité de dopage des plans de masse 93 et 97 respectivement. Un tel dopage peut être obtenu lors des implantations respectives des plans de masse 93 et 97. De façon similaire, la densité du deuxième élément semi-conducteur 44 est au moins dix fois inférieure à la densité de dopage du plan de masse 94.

Ainsi, lors d'une implantation d'un plan de masse, avec une profondeur d'implantation maximale disposée sous la couche d'isolant enterrée 2, la densité de dopage de même type dans le semi-conducteur disposé sur la couche isolante enterrée 2 est suffisante pour former une base d'un transistor bipolaire. Plus le dopage résiduel des bases 43 et 47 à l'issue de cette implantation est faible, plus on peut appliquer des niveaux de tension de polarisation faibles sur les plans de masse 93 et 97. Le dopage des bases 43 et 47 présente typiquement une densité inférieure à 10¹⁸cm⁻³, de préférence inférieure à 5*10¹⁷cm⁻³. Pour accroître l'influence du contrôle électrostatique d'un plan de masse sur la base disposée à son aplomb, la couche isolante enterrée présente avantageusement une épaisseur inférieure ou égale à 25 nm, voire inférieur ou égale à 15 nm.

Dans cette variante, la face supérieure des bases 43 et 47 et de l'élément semi-conducteur 44 est en retrait par rapport à la face supérieure de l'émetteur 42 et de l'élément semi-conducteur 45. La formation de l'émetteur 42 et de l'élément semi-conducteur 45 peut par exemple être poursuivie lors d'une phase de reprise d'épitaxie.

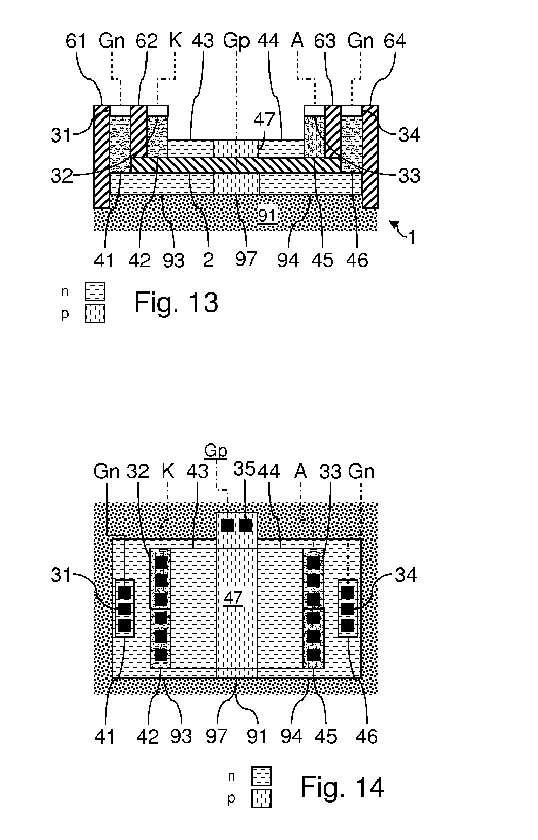

La figure 13 est une vue en coupe transversale d'une deuxième variante d'un dispositif de protection contre les décharges électrostatiques selon un troisième mode de réalisation. La figure 14 est une vue de dessus du dispositif de protection contre les décharges électrostatiques de la figure 13. Dans un souci de lisibilité, les tranchées d'isolation 61 à 64 n'ont pas été illustrées.

Cette variante reprend l'ensemble des caractéristiques de la première variante, les principales différences étant que :
- l'émetteur du transistor NPN comprend un élément semi-conducteur 42 et un élément semi-conducteur 43 ;
- l'élément semi-conducteur 47 forme la base du transistor NPN ;
- l'élément semi-conducteur 45 forme l'émetteur du transistor PNP ;
- l'élément semi-conducteur 44 forme la base du transistor PNP ;
- le dopage des zones implantées 41, 46, de la base 44, des éléments semi-conducteurs 42 et 43 et des plans de masse 93 et 94 est de type n ;
- le dopage de la base 47, de l'émetteur 45, du plan de masse 97 est de type p ;
- une polarisation V_{Gn} est appliquée sur le plan de masse 97 ;
- une polarisation V_{Gp} est appliquée sur les plans de masse 93 et 94.

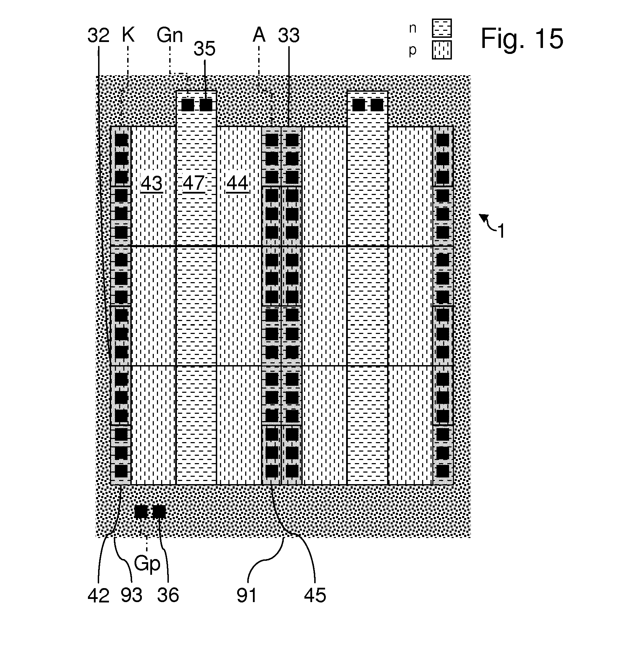

La figure 15 est une vue de dessus d'un ensemble de dispositifs de protection selon la figure 11 accolés dans un circuit intégré 1. Cette figure permet de constater que la polarisation des plans de masse 97 par l'intermédiaire de contacts métalliques peut être réalisée de façon commune pour plusieurs dispositifs de protection contre les décharges, avec un minimum d'encombrement.

Bien que non illustré, on peut également envisager que les tranchées d'isolation 61 à 64 du troisième mode de réalisation présentent une même profondeur. On peut également envisager les faces supérieures des éléments semi-conducteurs 43, 44 et 47 sont affleurantes avec les faces supérieures des émetteurs 42 et 45. Le dopage d'un des éléments semi-conducteurs 43, 44 ou 47 peut également être de type LDD.

La figure 16 est une vue en coupe transversale d'un circuit intégré 1, au niveau d'un dispositif de protection contre les décharges électrostatiques selon une première variante d'un quatrième mode de réalisation de l'invention. Le circuit intégré 1 comporte d'autres composants électroniques non illustrés ici.

Cette variante diffère de la première variante du premier mode de réalisation uniquement par la présence d'un élément d'isolation 65 s'étendant entre la couche isolante enterrée 2 et le substrat 91. L'élément d'isolation 65 est positionné à l'aplomb du contact entre les bases 43 et 44. L'élément d'isolation 65 s'étend dans le substrat 91 plus profondément que les plans de masse 93 et 94. L'élément 65 s'étend ici jusqu'à la même profondeur que les tranchées d'isolation 61 et 64. L'élément d'isolation 65 isole électriquement les plans de masse 93 et 94 l'un de l'autre. Une telle isolation permet de réduire les fuites entre les plans de masse 93 et 94 et également de réduire les capacités parasites en vue d'améliorer les performances en haute fréquence. Par ailleurs, il est possible d'utiliser une plus grande variété de potentiels de polarisation sur les plans de masse 93 et 94.

Dans ce mode de réalisation, les projections des plans de masse 93 et 94 sur la couche 2 (selon une normale à la couche 2) n'incluent pas les projections respectives des bases 43 et 44 sur cette couche 2. Cependant, une proportion suffisante des plans de masse 93 et 94 reste à l'aplomb respectivement des bases 43 et 44 pour garantir un contrôle électrostatique de celles-ci. En particulier, les plans de masse 93 et 94 s'étendent à l'aplomb respectivement des contacts émetteur 42/base 43 et émetteur 45/base 44.

La figure 17 est une vue en coupe transversale d'un circuit intégré 1, au niveau d'un dispositif de protection contre les décharges électrostatiques selon une deuxième variante du quatrième mode de réalisation de l'invention. Cette variante diffère de la première variante en ce qu'il comprend en outre une autre couche d'isolation enterrée 66, disposée sous les plans de masse 93 et 94 et s'étendant entre les tranchées d'isolation 61 et 64. La couche d'isolation enterrée 66 isole électriquement les plans de masse 93 et 94 du substrat 91. La couche 66 présente également une partie en saillie entre les plans de masse 93 et 94 et s'étendant jusqu'à la couche isolante enterrée 2, de façon à isoler les plans de masse 93 et 94 l'un de l'autre. Du fait de l'isolation par rapport au substrat 91, on peut ainsi une tension de polarisation du plan de masse 93 supérieure à la tension de polarisation du plan de masse 94.

Dans les différentes variantes, le substrat 91 et la couche semi-conductrice sont en silicium, d'autres matériaux semi-conducteurs pouvant toutefois également être utilisés.

Par des mesures, on a pu vérifier une relation très linéaire entre la tension de polarisation d'un plan de masse sous une base et la tension de déclenchement d'un dispositif de protection contre les décharges électrostatiques selon l'invention. On a pu constater qu'une tension de polarisation d'un plan de masse présentant un niveau logique usuel permettait en outre d'obtenir une tension de déclenchement du dispositif de protection supérieure à ce niveau logique.

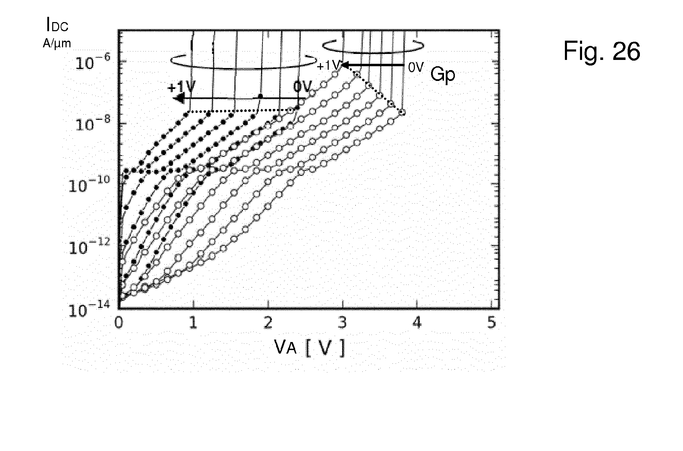

Des mesures ont également été effectuées avec un circuit intégré correspondant à la première variante du deuxième mode de réalisation, ainsi qu'avec une autre variante de ce deuxième mode de réalisation. La figure 26 fournit des diagrammes illustrant la densité de courant I_{A} en fonction de la tension d'anode (VA), pour différentes tensions V_{Gp} de polarisation du plan de masse placé sous la base à dopage de type p. Les diagrammes de la partie gauche de la figure correspondent à la première variante du deuxième mode de réalisation, avec des bases flottantes. Les diagrammes de la partie droite de la figure correspondent à déclinaison de cette première variante du deuxième mode de réalisation, dans laquelle la cathode métallique 32 en contact avec la zone implantée 42 déborde jusqu'en contact avec la base 43.

Ce diagramme confirme la grande linéarité entre la tension de polarisation Gp et la tension de déclenchement Vt1 (la tension de déclenchement se déduit des diagrammes à l'intersection entre ceux-ci et un segment en pointillés), que ce soit pour une tension Gp positive ou négative. On constate en outre que le contrôle par une tension Gp comprise entre 0 et +1 V permet d'obtenir une tension de déclenchement Vt1 comprise entre 1 et 3,9V, selon si la base 43 est flottante ou si la base 43 est court-circuitée à la cathode métallique 32.

Dans les différentes variantes détaillées, les bases ne sont pas connectées à un circuit de contrôle des courants de base.

## Revendications

1. Circuit intégré (1) comprenant un dispositif de protection contre les décharges électrostatiques, **caractérisé en ce que** ce dispositif de protection comprend :
- une couche isolante enterrée (2) comportant une épaisseur inférieure ou égale à 50nm ;
- des premiers et deuxième transistors bipolaires disposés sur la couche isolante enterrée (2), un de ces transistors bipolaires étant un transistor NPN, l'autre de ces transistors étant un transistor PNP, la base du premier transistor bipolaire étant confondue avec le collecteur du deuxième transistor bipolaire et la base du deuxième transistor bipolaire étant confondue avec le collecteur du premier transistor bipolaire, les premier et deuxième transistors bipolaires étant configurés pour conduire sélectivement un courant de décharge entre deux électrodes (A, K) du dispositif de protection ;
- un premier plan de masse semi-conducteur (93) disposé sous la couche isolante enterrée, adapté à être polarisé électriquement, s'étendant à l'aplomb de la base (43) du premier transistor bipolaire, présentant un premier type de dopage identique à celui de la base du premier transistor bipolaire et présentant une densité de dopage au moins dix fois supérieure à celle de la base du premier transistor bipolaire.

2. Circuit intégré (1) selon la revendication 1, dans lequel la densité de dopage dans la base (43) du premier transistor bipolaire est inférieure ou égale à 10¹⁸cm⁻³.

3. Circuit intégré (1) selon la revendication 1 ou 2, dans lequel les bases des premier et deuxième transistors bipolaires sont formés dans une couche semi-conductrice présentant une épaisseur inférieure ou égale à 15nm.

4. Circuit intégré (1) selon l'une quelconque des revendications précédentes, comprenant un deuxième plan de masse semi-conducteur (94) disposé sous la couche d'isolant enterrée (2), polarisé électriquement, présentant un deuxième type de dopage et s'étendant à l'aplomb de la base (44) du deuxième transistor bipolaire, lesdits premier et deuxième types de dopage étant différents.

5. Circuit intégré (1) selon la revendication 4, dans lequel lesdits premiers et deuxième plans de masse (93, 94) sont en contact.

6. Circuit intégré (1) selon la revendication 5, dans lequel les projections respectives des premier et deuxième plans de masse (93, 94) sur la couche isolante enterrée (2) incluent les projections respectives des bases (43, 44) des premier et deuxième transistors bipolaires sur la couche isolante enterrée (2).

7. Circuit intégré (1) selon la revendication 4, comprenant en outre un élément isolant électriquement (66), cet élément séparant les premier et deuxième plans de masse (93, 94) et étant disposé à l'aplomb de la jonction entre la base (43) du premier transistor bipolaire et la base (44) du deuxième transistor bipolaire.

8. Circuit intégré (1) selon l'une quelconque des revendications précédentes, dans lequel ledit premier transistor bipolaire est dépourvu d'électrode en contact avec sa base (43).

9. Circuit intégré (1) selon l'une quelconque des revendications précédentes, dans lequel les faces supérieures des bases (43, 44) et des émetteurs (42, 45) desdits premier et deuxième transistors bipolaires sont affleurantes.

10. Circuit intégré selon l'une quelconque des revendications précédentes, comprenant en outre un transistor FDSOI formé sur ladite couche isolante enterrée (2) et un plan de masse semi-conducteur disposé sous ladite couche isolante enterrée (2) à l'aplomb dudit transistor FDSOI.

11. Procédé de fabrication d'un circuit intégré (1) comprenant un dispositif de protection contre les décharges électrostatiques, comprenant :
- l'implantation d'un premier type de dopage dans un substrat semi-conducteur (91) disposé sous une couche isolante enterrée (2), la couche isolante enterrée présentant une épaisseur inférieure ou égale à 50nm, de façon à former un premier plan de masse (93),
- la formation de premier et deuxième transistors bipolaires dont un transistor NPN et un transistor PNP sur la couche isolante enterrée (2), la base (43) du premier transistor présentant le premier type de dopage et les bases respectives des premier et deuxième transistors bipolaires étant confondues avec les collecteurs respectifs des deuxième et premier transistors bipolaires, la base (43) du premier transistor bipolaire étant formée à l'aplomb du premier plan de masse (93), le dopage de la base du premier transistor étant réalisé durant l'implantation du premier type de dopage de formation dudit premier plan de masse, la densité de dopage à l'issue de l'implantation dans le premier plan de masse étant au moins dix fois supérieure à celle de la base du premier transistor bipolaire.

12. Procédé de fabrication selon la revendication 11, comprenant des étapes de :
- formation d'une électrode (31) connectée électriquement avec ledit premier plan de masse (93) ;
- interconnexion de ladite électrode avec un circuit de polarisation.

13. Procédé de fabrication selon la revendication 12, dans lequel la densité de dopage dans la base (43) du premier transistor après la formation de l'interconnexion avec le circuit de polarisation est inférieure ou égale à 10¹⁸cm⁻³.

14. Procédé de fabrication selon l'une quelconque des revendications 11 à 13, dans lequel les premier et deuxième transistors bipolaires sont formés dans une couche semi-conductrice (4) disposée sur ladite couche isolante enterrée (2), le procédé comprenant des étapes d'implantation de dopage dans la couche semi-conductrice (4), ces étapes d'implantation étant postérieures à l'implantation de formation dudit premier plan de masse (93), la base du premier transistor bipolaire étant masquée durant chacune de ces étapes d'implantation postérieures.

15. Procédé de fabrication selon l'une quelconque des revendications 11 à 14, dépourvu d'étape de formation d'une électrode en contact avec la base (43) dudit premier transistor bipolaire.
